# EUROPÄISCHE PATENTSCHRIFT

(11) **EP 2 859 566 B1**
(45) Veröffentlichungstag und Bekanntmachung des Hinweises auf die Patenterteilung: **31.07.2019**
(21) Anmeldenummer: 13737551.5
(22) Anmeldetag: 06.06.2013
(51) Int. Cl.: H01C 7/10, H01G 4/30, H01C 1/14, H01C 7/18, H01G 4/012, H01L 41/047, H01L 41/083, H01L 41/29, H01C 17/00, H01C 17/28, H01G 4/005

(54) **VERFAHREN ZUR HERSTELLUNG EINES VIELSCHICHTBAUELEMENTS UND VIELSCHICHTBAUELEMENT**
METHOD FOR PRODUCING A MULTI-LAYER COMPONENT AND MULTI-LAYER COMPONENT
PROCÉDÉ DE FABRICATION D'UN ÉLÉMENT MULTICOUCHE ET ÉLÉMENT MULTICOUCHE

(30) Priorität: 12.06.2012 DE 102012105059
(43) Veröffentlichungstag der Anmeldung: 15.04.2015
(73) Patentinhaber: TDK Electronics AG, 81671 München (DE)
(72) Erfinder: RINNER, Franz, 8530 Deutschlandsberg (AT); SOMITSCH, Dieter, 8522 Groß St. Florian (AT); AUER, Christoph, 8043 Graz (AT); FUCHS, Gerhard, 4652 Steinerkirchen (AT)
(74) Vertreter: Epping - Hermann - Fischer
(86) Internationale Anmeldenummer: PCT/EP2013/061724
(87) Internationale Veröffentlichungsnummer: WO 2013/186121

(56) Entgegenhaltungen:
- WO-A1-2011/099381
- DE-A1-102006 001 656

## Beschreibung

Es wird ein Verfahren zur Herstellung eines Vielschichtbauelements und ein Vielschichtbauelement angegeben. Das Vielschichtbauelement kann als Piezoaktor ausgebildet sein, der beispielsweise zum Betätigen eines Einspritzventils in einem Kraftfahrzeug eingesetzt wird. Das Vielschichtbauelement kann auch als Varistor, Kondensator, Heißleiter oder Kaltleiter ausgebildet sein.

In den Druckschriften DE 10 2006 001 656 A1, DE 44 10 504 B4 und DE 10 2007 004 813 A1 sind elektrochemische Ätzverfahren zur Ausbildung von Isolationszonen in Vielschichtbauelementen beschrieben.

Es ist eine zu lösende Aufgabe, ein verbessertes Verfahren zur Herstellung eines Vielschichtbauelements und ein Vielschichtbauelement mit verbesserten Eigenschaften anzugeben.

Es wird ein Verfahren, mit den Merkmalen gemäß Anspruch 1, zur Herstellung eines Vielschichtbauelements angegeben, bei dem ein Körper bereitgestellt wird, der übereinander angeordnete dielektrische Schichten und dazwischen angeordnete erste und zweite elektrisch leitfähige Schichten aufweist. Vorzugsweise weist der Körper eine Vielzahl von ersten leitfähigen Schichten und eine Vielzahl von zweiten leitfähigen Schichten auf. Es kann aber auch nur eine erste leitfähige Schicht vorhanden sein. Weiterhin kann auch nur eine zweite leitfähige Schicht vorhanden sein. Im Folgenden wird für die ersten und zweiten leitfähigen Schichten zumeist der Plural verwendet, wobei aber hier auch Ausführungsformen eingeschlossen sind, bei der nur eine erste leitfähige Schicht oder nur eine zweite leitfähige Schicht vorhanden ist.

Durch das Verfahren wird vorzugsweise ein piezoelektrisches Bauelement hergestellt, insbesondere kann das Vielschichtbauelement als Piezoaktor ausgebildet sein. Die dielektrischen Schichten sind beispielsweise keramische Schichten, insbesondere piezokeramische Schichten.

In einer Ausführungsform dienen die ersten und zweiten leitfähigen Schichten im Vielschichtbauelement als Elektroden. Insbesondere können die Elektroden als Elektrodenschichten ausgebildet sein.

Vorzugsweise wird im Betrieb des Bauelements zwischen die Elektroden eine Spannung angelegt. In diesem Fall werden mit dem hier beschriebenen Verfahren beispielsweise Isolationszonen hergestellt. Beispielsweise dienen die Isolationszonen dazu, die ersten und zweiten leitfähigen Schichten abwechselnd von einer Außenseite des Körpers zu isolieren. Somit können die ersten leitfähigen Schichten durch eine Außenkontaktierung, die auf einer Außenseite des Stapels angeordnet ist, gemeinsam elektrisch kontaktiert werden, während die zweiten leitfähigen Schichten von dieser Außenkontaktierung isoliert sind. Ebenso können die zweiten leitfähigen Schichten von einer weiteren Außenkontaktierung gemeinsam elektrisch werden, die auf einer weiteren Seite des Stapels angeordnet ist, während die ersten leitfähigen Schichten von dieser Außenkontaktierung isoliert sind.

Alternativ oder zusätzlich können durch das hier beschriebene Verfahren Sollbruchbereiche gebildet werden. Beispielsweise können die Sollbruchbereiche gleichzeitig als Isolationszonen fungieren.

Ein Sollbruchbereich ist vorzugsweise eine Schwachstelle im Bauelement, die zur gezielten Erzeugung und Führung von Rissen dient. Auf diese Weise kann eine unkontrollierte Entstehung und Ausbreitung von Rissen im Bauelement verhindert werden, so dass die Gefahr von Kurschlüssen reduziert wird. Dei Gefahr von Rissen ist besonders groß, wenn benachbarte Elektrodenschichten im Bauelement abwechselnd bis zu einer Seitenfläche geführt und von der gegenüberliegenden Seitenfläche beabstandet sind. Dadurch entstehen inaktive Zonen im Bauelement, in denen mechanische Spannungen entstehen können.

In einer weiteren Ausführungsform hat wenigstens eine der ersten und zweiten leitfähigen Schichten im Vielschichtbauelement keine Funktion als Elektrodenschicht.

Vorzugsweise haben die ersten leitfähigen Schichten im Vielschichtbauelement keine Funktion als Elektrodenschicht. Vorzugsweise wird in diesem Fall durch das Verfahren ein Sollbruchbereich gebildet. Insbesondere kann an der Position einer leitfähigen Schicht, die keine Funktion als Elektrodenschicht im Vielschichtbauelement hat, ein Sollbruchbereich gebildet werden. In einer Ausführungsform wird diese leitfähige Schicht während des Verfahrens vollständig entfernt.

Die ersten und zweiten leitfähigen Schichten können in Stapelrichtung abwechselnd angeordnet sein. Es können aber auch zwischen zwei aufeinander folgenden ersten leitfähigen Schichten mehrere zweite leitfähige Schichten angeordnet sein.

Die erste leitfähige Schicht ist mit einer ersten Hilfselektrode und die zweite leitfähige Schicht ist mit einer zweiten Hilfselektrode verbunden.

Die Hilfselektroden sind auf zwei gegenüberliegenden Seitenflächen des Körpers angeordnet. Die Hilfselektroden sind vorzugsweise nur temporär vorhanden und insbesondere im späteren Vielschichtbauelement nicht mehr vorhanden.

In einem Verfahrensschritt wird zumindest ein Teil des Körpers in ein Medium, insbesondere eine Flüssigkeit eingebracht. Vorzugsweise handelt es sich um einen Elektrolyten. Das Medium ist ein Ätzmedium. Beispielsweise ist die erste Hilfselektrode an einer ersten Seitenfläche des Körpers angeordnet und die zweite Hilfselektrode an einer zweiten Seitenfläche angeordnet und es wird wenigstens eine dritte Seitenfläche des Körpers in das Medium eingebracht.

Es wird zwischen der ersten und zweiten Hilfselektrode eine Spannung angelegt. Auf diese Weise kann ein Materialabtrag aus wenigstens einer der ersten und zweiten elektrisch leitfähigen Schichten erzeugt werden. Beispielsweise ist der Materialabtrag elektrisch gesteuert, insbesondere durch einen elektrochemischen Ätzprozess erzeugt. Dabei werden vorzugsweise Vertiefungen im Körper gebildet, insbesondere können Vertiefungen an der Position der ersten leitfähigen Schicht gebildet werden.

Mit dem Anlegen einer Spannung kann beispielsweise ein Materialtransport zwischen den ersten und zweiten elektrisch leitfähigen Schichten gesteuert werden. Dabei kann sich beispielsweise Material, insbesondere elektrisch leitfähiges Material wie z. B. ein Metall, aus einer ersten leitfähigen Schicht herauslösen und auf einer zweiten elektrisch leitfähigen Schicht abscheiden. Diese Schicht, kann beispielsweise mehrere µm dick sein und Kupfer aufweisen.

In einer Ausführungsform wird wenigstens eine der elektrisch leitfähigen Schichten, insbesondere eine erste leitfähige Schicht, elektrisch gesteuert geätzt. In einer weiteren Ausführungsform kann sich das Material aus einer der elektrisch leitfähigen Schichten, insbesondere aus einer ersten leitfähigen Schicht, galvanisch herauslösen.

Vorzugsweise wird auf wenigstens einer der elektrisch leitfähigen Schichten, insbesondere einer zweiten leitfähigen Schicht, Material elektrisch gesteuert abgeschieden. Vorzugsweise wird eine Beschichtung erzeugt.

Beispielsweise wird Materialabscheidung durch einen galvanischen Prozess erzeugt. Beispielsweise wandert das aus einer ersten leitfähigen Schicht herausgelöste Material zur zweiten elektrisch leitfähigen Schicht und lagert sich dort an. Eine Beschichtung der leitfähigen Schicht kann zu einer Verbesserung der elektrischen Kontaktierung der Schicht führen. Insbesondere kann durch das auf der leitfähigen Schicht abgeschiedene Material ein unerwünschter Materialabtrag, z. B. in einem Ätzprozess, kompensiert werden.

In einer Ausführungsform kann zusätzlich eine dritte Hilfselektrode in das Medium eingebracht werden. Die dritte Hilfselektrode ist vorzugsweise nicht mit dem Bauelement verbunden, sondern separat vom Bauelement angeordnet. Durch die dritte Hilfselektrode ist es möglich, den Materialabtrag und/oder die Abscheidung von Material besonders kontrolliert durchzuführen.

Die dritte Hilfselektrode kann auf das gleiche Potential gesetzt werden wie die erste oder zweite Hilfselektrode. In diesem Fall wird die dritte Hilfselektrode vorzugsweise auf das gleiche Potential gesetzt wie die zweite Hilfselektrode. Alternativ kann die dritte Hilfselektrode auf ein Potential gesetzt werden, das sich vom Potential der ersten und der zweiten Hilfselektrode unterscheidet. Vorzugsweise wird die dritte Hilfselektrode dabei auf ein Potential gesetzt, dass zwischen den Potentialen der ersten und zweiten Hilfselektrode liegt. Besonders bevorzugt wird die erste Hilfselektrode auf ein positives Potential, die zweite Hilfselektrode auf ein negatives Potential und die dritte Hilfselektrode auf ein negativeres Potential als die zweite Hilfselektrode gesetzt.

In einer bevorzugten Ausführungsform wird der Köper vor dem Einbringen in das Medium gesintert.

Auf diese Weise werden die durch den Materialabtrag eingebrachten Vertiefungen nicht durch spätere Sinterprozesse verändert, insbesondere mit dielektrischem Material aufgefüllt. Somit können die Vertiefungen ihre Funktion als Sollbruchbereiche besonders gut erfüllen. Weiterhin kann bei einem gesinterten Körper die Geometrie der Vertiefung gut definiert werden. Beispielsweise können sehr schmale Vertiefungen erzeugt werden, so dass sehr schmale Isolationszonen und Sollbruchbereiche gebildet werden. Auf diese Weise wird der aktive Bereich des Vielschichtbauelements, durch den die Leistung erzeugt wird, durch die Isolationszonen und Sollbruchbereiche nur wenig verringert.

Vorzugsweise wird in wenigstens einer Stufe des Prozesses des Materialabtrags die erste Hilfselektrode mit einem positiven Potential beaufschlagt, während die zweite Hilfselektrode mit einem negativen Potential beaufschlagt wird.

Das Anlegen eines negativen und eines positiven Potentials ermöglicht es, den Materialabtrag und die Abscheidung von Material besonders kontrolliert durchzuführen. Insbesondere kann ein Abtrag von Material aus einer zweiten elektrisch leitfähigen Schicht durch das Beaufschlagen mit einem negativen Potential verhindert werden. Dies ist insbesondere von Vorteil, wenn als Medium ein starkes Ätzmedium verwendet wird, das auch ohne Anlegen einer Spannung die elektrisch leitfähigen Schichten ätzen kann. An den über die Hilfselektrode unter negatives Potential gesetzten leitfähigen Schichten kann dadurch beispielsweise eine Metallschicht abgeschieden werden. Dies kann für bestimmte Weiterkontaktierungskonzepte von Vorteil sein.

Das Medium, insbesondere ein Ätzmedium, ist in einer Ausführungsform derart gewählt, dass die dielektrischen Schichten, insbesondere keramische Schichten, nur wenig oder gar nicht angegriffen werden. Beispielsweise weist das Medium Eisen(III)-chlorid, Natriumpersulfat oder Kupferchlorid (CuCl₂) auf.

In einer Ausführungsform enthält wenigstens eine der ersten und zweiten leitfähigen Schichten Kupfer oder besteht aus Kupfer. Vorzugsweise enthält wenigstens die erste leitfähige Schicht Kupfer. Besonders bevorzugt enthalten sowohl die ersten als auch die zweiten leitfähigen Schichten Kupfer. Vorzugsweise weisen alle elektrisch leitfähigen Schichten dieselbe Materialzusammensetzung auf.

Die Verwendung von Kupfer in der leitfähigen Schicht ermöglicht einen einfacheren Materialabtrag, insbesondere in einem Ätzprozess. Beispielsweise kann Kupfer mit einer breiten Palette an milden Chemikalien geätzt werden. Bei leitfähigen Schichten aus Silber oder Silber-Palladium sind aggressivere Ätzmedien zur Ätzung erforderlich, die insbesondere auch die dielektrischen Schichten angreifen können.

Durch den Ätzprozess wird vorzugsweise zumindest teilweise das Kupfer aus der leitfähigen Schicht entfernt. Die oben genannten Ätzmedien eignen sich besonders gut zum Ätzen von Kupfer.

In einer Ausführungsform wird der Körper nur teilweise in das Medium eingebracht. Beispielsweise wird der Körper mit einer Seitenfläche in das Medium eingebracht.

Dies ermöglicht es, gezielt auf dieser Seitenfläche einen Materialabtrag durchzuführen, während auf einer weiteren Seitenfläche, insbesondere einer gegenüberliegenden Seitenfläche in dieser Stufe kein Materialabtrag durchgeführt wird.

In einer Ausführungsform wird der Körper vollständig in das Medium eingebracht. In diesem Fall kann ein Materialabtrag in allen Bereichen in einer Stufe durchgeführt werden.

In einer Ausführungsform wird ein mehrstufiger Materialabtragungsprozess, insbesondere ein mehrstufiger Ätzprozess, durchgeführt.

Dabei kann der Körper in einer ersten Stufe nur mit einem ersten Teil, beispielsweise einer Seitenfläche, in das Medium eingebracht werden. In einer zweiten Stufe wird der Körper vorzugsweise mit einem anderen Teil, beispielsweise einer gegenüberliegenden Seitenfläche, in das Medium eingebracht. Dies ermöglicht einen Materialabtrag, insbesondere eine Ätzung, gezielt an vordefinierten Teilen des Körpers. Vorzugsweise wird die Polarität der Hilfselektroden zwischen den Stufen getauscht.

Beispielsweise wird in der ersten Stufe an die erste Hilfselektrode ein positives Potential und an die zweite Hilfselektrode ein negatives Potential angelegt. In der zweiten Stufe wird an die erste Hilfselektrode in negatives Potential und an die zweite Hilfselektrode ein positives Potential angelegt. Dies ermöglicht es, in der ersten Stufe beispielsweise gezielt aus den ersten leitfähigen Schichten und in der zweiten Stufe gezielt aus den zweiten leitfähigen Schichten Material abzutragen.

In einer Ausführungsform wird ein einstufiger Materialabtragungsprozess, insbesondere ein einstufiger Ätzprozess, durchgeführt.

In einem einstufigen Prozess wird nur in einer Stufe Material abgetragen. Insbesondere wird keine Vertauschung der Polarität der Hilfselektroden vorgenommen. Vorzugsweise wird der Körper nur einmal in das Medium eingebracht.

Der einstufige Materialabtragungsprozess eignet sich besonders gut, wenn die ersten leitfähigen Schichten keine Funktion als Elektroden im Vielschichtbauelement übernehmen. In diesem Fall werden in dem einstufigen Prozess vorzugsweise Sollbruchbereiche an der Position der ersten leitfähigen Schichten gebildet. Beispielsweise wird die erste leitfähige Schicht im Materialabtragungsprozess vollständig entfernt.

In einer Ausführungsform weist der Körper dritte leitfähige Schichten auf, die mit der zweiten Hilfselektrode verbunden sind. Es kann auch nur eine dritte leitfähige Schicht vorhanden sein. Die dritten leitfähigen Schichten weisen eine andere Geometrie auf als die zweiten leitfähigen Schichten. Beispielsweise bedeckt eine zweite leitfähige Schicht nur einen Teil einer dielektrischen Schicht während ein Teil der dielektrischen Schicht unbedeckt ist. Eine dritte leitfähige Schicht bedeckt ebenfalls nur einen Teil einer dielektrischen Schicht, wobei der unbedeckte Teil an einer anderen Position angeordnet ist als bei der zweiten leitfähigen Schicht.

In einer Ausführungsform dienen die zweiten und dritten leitfähigen Schichten im Vielschichtbauelement als Elektroden.

Dabei können schon vor dem Materialabtrag Isolationszonen vorhanden sein, die die zweiten und dritten leitfähigen Schichten von Außenseiten des Körpers abwechselnd isolieren. Vorzugsweise werden in diesem Fall während des Materialabtrags keine Isolationszonen für die späteren Elektroden sondern nur Sollbruchbereiche gebildet. Die ersten leitfähigen Schichten dienen beispielsweise nur zur Ausbildung der späteren Sollbruchbereiche.

Beispielsweise sind die ersten leitfähigen Schichten nur in Bereichen angeordnet, die zu Seitenflächen des Körpers benachbart sind. Insbesondere ist dann bei einer dielektrischen Schicht, auf die eine erste leitfähige Schicht aufgebracht ist, ein mittiger Bereich frei von der ersten leitfähigen Schicht.

Auf diese Weise kann die Geometrie der eingebrachten Vertiefungen besonders gut kontrolliert werden. Die Vertiefung verläuft dann ebenfalls nur in der Nähe der Seitenfläche und nicht in einen mittigen Bereich hinein.

In einer Ausführungsform des Verfahrens werden in einem weiteren Schritt die Hilfselektroden entfernt. Dabei werden beispielsweise Enden des Körpers, an denen Hilfselektroden angeordnet sind, vom Körper abgetrennt.

In einer Ausführungsform des Verfahrens wird in einem weiteren Schritt der Körper in mehrere Grundkörper für Vielschichtbauelemente getrennt. Alternativ kann aber auch vorgesehen sein, dass aus dem Körper nur ein Grundkörper für ein Vielschichtbauelement gebildet wird.

In einer Ausführungsform des Verfahrens wird in einem weiteren Schritt wenigstens eine Außenkontaktierung zur Kontaktierung des Vielschichtbaulements auf eine Seitenfläche aufgebracht. Die Außenkontaktierung wird vorzugsweise nach dem Abschluss des Materialabtrags aufgebracht. Die Außenkontaktierung kann auf den Körper vor einer Zerlegung in mehrere Grundkörper oder erst auf die einzelnen Grundkörper aufgebracht werden.

Vorzugsweise werden eine erste und eine zweite Außenkontaktierung aufgebracht. Die erste Außenkontaktierung wird beispielsweise mit den ersten leitfähigen Schichten und die zweite Außenkontaktierung mit den zweiten leitfähigen Schichten elektrisch verbunden. Alternativ kann die erste Außenkontaktierung mit den dritten leitfähigen Schichten und die zweite Außenkontaktierung mit den zweiten leitfähigen Schichten verbunden werden.

Weiterhin wird ein Vielschichtbauelement mit den Merkmalen gemäß Anspruch 18 angegeben, das einen Grundkörper mit übereinander angeordneten dielektrischen Schichten und dazwischen angeordneten Elektrodenschichten aufweist. Der Grundkörper weist wenigstens eine durch einen elektrochemisch gesteuerten Materialabtrag gebildete Vertiefung an. Vorzugsweise ist die Vertiefung eingeätzt. Vorzugsweise weist der Grundkörper mehrere Vertiefungen auf, insbesondere Vertiefungen die an unterschiedlichen Positionen entlang der Stapelrichtung angeordnet sind. Die Vertiefungen dienen vorzugsweise als Sollbruchbereiche.

Das Vielschichtbauelement kann mit dem hier beschriebenen Verfahren hergestellt werden und kann alle funktionellen und strukturellen Merkmale aufweisen, die bezüglich des Verfahrens beschrieben sind.

Die Vertiefung ist in einer Ebene senkrecht zur Stapelrichtung angeordnet, die frei von leitfähigem Material ist. Die Vertiefung ist in einer Ebene angeordnet, in der keine Elektrodenschicht angeordnet ist.

Besonders bevorzugt weisen die Ebenen, in denen Elektrodenschichten verlaufen, keine Sollbruchbereiche auf. In diesem Fall kann verhindert werden, dass Risse in den Ebenen von Elektrodenschichten verlaufen. Dadurch kann die Zuverlässigkeit des Bauelements erhöht werden.

Im Folgenden werden die hier beschriebenen Gegenstände anhand von schematischen und nicht maßstabsgetreuen Ausführungsbeispielen näher erläutert.

Es zeigen:
- Figur 1: eine schematische perspektivische Ansicht eines Körpers zur Herstellung von Vielschichtbauelementen,
- Figur 2: eine Aufsicht auf eine dielektrische Schicht aufweisend eine erste leitfähige Schicht für einen blockförmigen Körper zur Herstellung des Körpers aus Figur 1,
- Figur 3: eine Aufsicht auf eine dielektrische Schicht aufweisend eine zweite leitfähige Schicht für einen blockförmigen Körper zur Herstellung des Körpers aus Figur 1,
- Figur 4: in schematischer Form der Ablauf eines Verfahrens zur Herstellung eines Vielschichtbauelements,
- Figur 5: im Querschnitt der Körper aus Figur 1 vor dem Materialabtrag,
- Figur 6: im Querschnitt der Körper aus Figur 1 nach dem Materialabtrag,
- Figur 7: im Schliffbild ein Grundkörper eines Vielschichtbauelements aufweisend Vertiefungen hergestellt aus einem Körper gemäß Figur 1,
- Figur 8: eine schematische perspektivische Ansicht eines Körpers gemäß einer weiteren Ausführungsform zur Herstellung von Vielschichtbauelementen,
- Figur 9: eine Aufsicht auf eine dielektrische Schicht aufweisend eine erste leitfähige Schicht für einen blockförmigen Körper zur Herstellung des Körpers aus Figur 8,
- Figur 10: eine Aufsicht auf eine dielektrische Schicht aufweisend eine zweite leitfähige Schicht für einen blockförmigen Körper zur Herstellung des Körpers aus Figur 8,
- Figur 11: eine Aufsicht auf eine weitere dielektrische Schicht aufweisend eine dritte leitfähige Schicht für einen blockförmigen Körper zur Herstellung des Körpers aus Figur 8,
- Figur 12: im Querschnitt der Körper aus Figur 8 vor dem Materialabtrag,
- Figur 13: im Querschnitt der Körper aus Figur 8 nach dem Materialabtrag.

Vorzugsweise verweisen in den folgenden Figuren gleiche Bezugszeichen auf funktionell oder strukturell entsprechende Teile der verschiedenen Ausführungsformen.

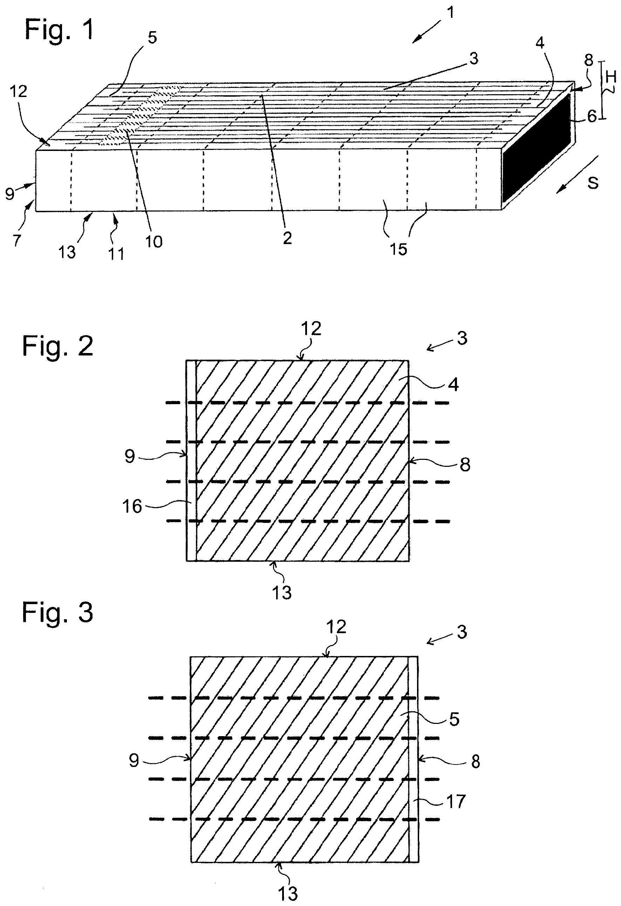

Figur 1 zeigt eine schematische perspektivische Ansicht eines Körpers 1 zur Herstellung von Vielschichtbauelementen.

Der Körper 1 ist als Riegel ausgebildet und kann entlang der eingezeichneten Trennlinien 2 in mehrere Grundkörper 15 für Vielschichtbauelemente zertrennt werden. Beispielsweise sind die Vielschichtbauelemente als Piezoaktoren ausgebildet.

Der Körper 1 und damit auch die später daraus gebildeten Grundkörper 15 weisen dielektrische Schichten 3 auf, die entlang einer Stapelrichtung S übereinander angeordnet sind. Zwischen den dielektrischen Schichten 3 sind erste und zweite leitfähige Schichten 4, 5 angeordnet. Die dielektrischen Schichten 3 enthalten beispielsweise ein Keramikmaterial. Vorzugsweise sind die dielektrischen Schichten 3 als piezoelektrische Schichten ausgebildet, insbesondere können sie ein piezokeramisches Material aufweisen.

Der abgebildete Körper 1 ist vorzugsweise ein gesinterter Körper, insbesondere wird der Körper 1 bereits vor Durchführung des hier beschriebenen Materialabtrags gesintert. Besonders bevorzugt ist der Körper 1 ein monolithischer Sinterkörper, so dass die leitfähigen Schichten 4, 5 zusammen mit den dielektrischen Schichten 3 gesintert sind. In einem alternativen Ausführungsbeispiel liegt der abgebildete Körper 1 im Grünzustand vor und wird erst nach dem Materialabtrag gesintert. Im Folgenden wird der Materialabtrag durch einen elektrisch gesteuerten Ätzprozess durchgeführt. Es kommen aber auch andere Prozesse, z. B. ein galvanischer Prozess, in Betracht.

Die ersten leitfähigen Schichten 4 sind abwechselnd mit den zweiten leitfähigen Schichten 5 entlang der Stapelrichtung S angeordnet. Die ersten leitfähigen Schichten 4 reichen bis zu einer ersten Seitenfläche 8, während die zweiten leitfähigen Schichten 5 von dieser Seitenfläche 8 beabstandet sind. Die zweiten leitfähigen Schichten 5 reichen bis zur zweiten Seitenfläche 9, während die ersten leitfähigen Schichten 4 von dieser Seitenfläche 9 beabstandet sind.

Die leitfähigen Schichten 4, 5 enthalten vorzugsweise ein Metall. Besonders bevorzugt enthalten die leitfähigen Schichten Kupfer oder bestehen aus Kupfer. In weiteren Ausführungsformen können die leitfähigen Schichten 4, 5 beispielsweise Silber oder Silber-Palladium enthalten.

Für die Durchführung des Materialabtrags, insbesondere einer Ätzung, sind zwei Hilfselektroden 6, 7 auf den gegenüberliegenden Seitenflächen 8, 9 des Körpers 1 angeordnet. Die erste Hilfselektrode 6 ist mit den ersten leitfähigen Schichten 4 und die zweite Hilfselektrode 7 mit den zweiten leitfähigen Schichten 5 elektrisch verbunden. Die Hilfselektroden 6, 7 dienen lediglich zur Durchführung des Materialabtrags und sind im späteren Vielschichtbauelement nicht mehr vorhanden.

Im vorliegenden Ausführungsbeispiel dienen die ersten und zweiten leitfähigen Schichten 4, 5 im späteren Vielschichtbauelement als Elektroden, zwischen die im Betrieb des Vielschichtbauelements eine Spannung angelegt wird. Zur elektrischen Kontaktierung der Elektrodenschichten wird in einem späteren Verfahrensschritt eine erste Außenkontaktierung 10 auf einer dritten Seitenfläche 12 und eine zweite Außenkontaktierung 11 auf einer vierten Seitenfläche 13 angeordnet. Die Außenkontaktierungen 10, 11 sind vor dem Ätzprozess noch nicht vorhanden und hier nur angedeutet.

In dem in Figur 1 gezeigten Körper 1 reichen sowohl die ersten als auch die zweiten leitfähigen Schichten 4, 5 bis zu den dritten und den vierten Seitenflächen 12, 13. Im nachfolgend beschriebenen Ätzschritt werden Isolationszonen ausgebildet, um die ersten leitfähigen Schichten 4 von der zweiten Außenkontaktierung 11 und die zweiten leitfähigen Schichten 5 von der ersten Außenkontaktierung 10 elektrisch zu isolieren. Die Isolationszonen sind beispielsweise 0,1 mm breit. Dazu werden die ersten leitfähigen Schichten 4 und die zweiten leitfähigen Schichten 5 teilweise zurückgeätzt, so dass die ersten leitfähigen Schichten 4 von der vierten Seitenfläche 13 und die zweiten leitfähigen Schichten 5 von der dritten Seitenfläche 12 beabstandet sind.

Weiterhin werden durch die im Ätzprozess entstehenden Vertiefungen Sollbruchbereiche gebildet, in denen Risse im Grundkörper gezielt entstehen und geführt werden. Dadurch kann verhindert werden, dass sich ein Riss unkontrolliert im Grundkörper ausbildet und bei einer Überbrückung von Elektrodenschichten zu Kurzschlüssen führt.

Nachfolgend wird ein Verfahren zur Herstellung des Körpers 1 beschrieben.

Es wird ein Block gebildet, in dem dielektrische Schichten 3 und leitfähige Schichten 4, 5 entlang der Stapelrichtung S übereinander gestapelt werden. Der Block weist eine größere Höhe H auf als der Körper 1. Durch Zerteilung des Blocks entlang Schnittebenen, die parallel zur Stapelrichtung S und senkrecht zur Ausdehnung H verlaufen, können mehrere Körper 1 hergestellt werden.

Die Figuren 2 und 3 zeigen Aufsichten auf mit leitfähigen Schichten 4, 5 bedruckte dielektrische Schichten 3 im Grünzustand, die zur Bildung eines Blocks abwechselnd übereinander gestapelt werden. Zwischen den mit leitfähigen Schichten 4, 5 bedruckten dielektrischen Schichten 3 können auch unbedruckte dielektrische Schichten angeordnet sein.

In Figur 2 ist eine dielektrische Schicht 3 gezeigt, auf der eine erste leitfähige Schicht 4 aufgebracht ist. Die erste leitfähige Schicht 4 ist von der zweiten Seitenfläche 9 beabstandet und reicht bis zu den drei restlichen Seitenflächen 8, 12, 13.

Figur 3 zeigt eine Aufsicht auf eine weitere dielektrische Schicht 3, auf der eine zweite leitfähige Schicht 5 aufgebracht ist. Die zweite leitfähige Schicht 5 ist von der ersten Seitenfläche 8 beabstandet und reicht bis zu den restlichen Seitenflächen 9, 12, 13. Somit sind temporäre Isolationszonen 16, 17 ausgebildet, die zur Isolierung der ersten leitfähigen Schichten 4 von der zweiten Hilfselektrode 7 und der zweiten leitfähigen Schichten 5 von der ersten Hilfselektrode 6 dienen.

Nach der Anordnung der dielektrischen Schichten 3 zu einem Block wird der Block gepresst und entlang der eingezeichneten Trennlinien 14 in die riegelförmigen Körper 1 aus Figur 1 zertrennt.

Danach wird der riegelförmige Körper 1 vorzugsweise entkohlt, gesintert und eventuell geschliffen. Auf die ersten und zweiten Seitenflächen 8, 9 werden anschließend Hilfselektroden 6, 7 aufgebracht, die die elektrisch leitfähigen Schichten 4,5 kontaktieren. Beispielsweise werden die Hilfselektroden 6, 7 als Außenmetallisierung ausgebildet. Dazu kann eine Metallisierungspaste aufgetragen werden, aus der die Hilfselektroden 6 ,7 gebildet werden.

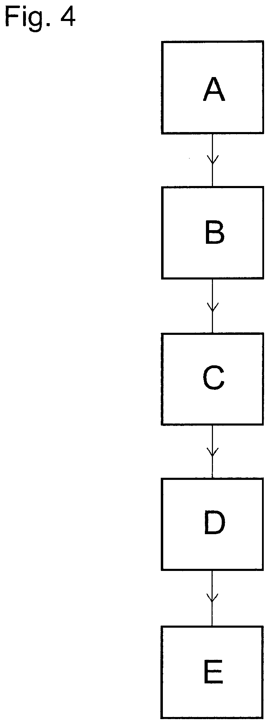

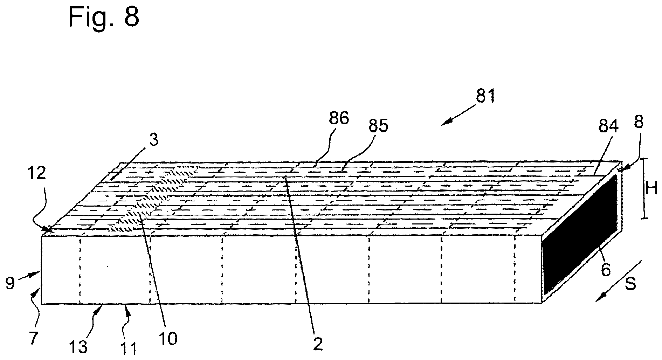

Figur 4 zeigt in schematischer Form den Ablauf eines Verfahrens zur Herstellung eines Vielschichtbauelements. Das Verfahren wird im Folgenden mit Bezug zum Körper 1 aus Figur 1 beschrieben, eignet sich aber auch für anders ausgestaltete Körper wie beispielsweise den in Figur 8 abgebildeten Körper 81.

In einem Schritt A wird der Körper 1 aufweisend die übereinander angeordneten dielektrischen Schichten 3 und dazwischen angeordneten ersten und zweiten elektrisch leitfähigen Schichten 4, 5 bereitgestellt. Die ersten leitfähigen Schichten 4 sind mit der ersten Hilfselektrode 6 verbunden und die zweiten leitfähigen Schicht 5 sind mit der zweiten Hilfselektrode 7 verbunden. Der Körper 1 ist vorzugsweise in diesem Verfahrenschritt bereits gesintert. Beispielsweise sind die Hilfselektroden 6, 7 als Metallpasten aufgebracht und zusammen mit den dielektrischen Schichten 3 und leitfähigen Schichten 4, 5 gesintert.

In einem nachfolgenden Schritt B wird zumindest ein Teil des Körpers 1 in ein Medium, insbesondere ein Ätzmedium, eingebracht.

Das Ätzmedium weist beispielsweise Natriumpersulfat auf. Es kann zum Beispiel 150 g Natriumpersulfat (Na₂S₂O₈) in 1 l Wasser gelöst werden. Damit kann man eine erste kupferhaltige leitfähige Schicht, die auf einem positiven Potential liegt, elektrisch gesteuert ätzen und eine zweite kupferhaltige leitfähige Schicht, die auf einem negativem Potential liegt, galvanisch beschichten.

Dabei wird das Kupfer aus der ersten leitfähigen Schicht herausgelöst und es werden Vertiefungen am Ort der leitfähigen Schicht eingefügt. Gleichzeitig schlägt sich das Kupfer an der zweiten leitfähigen Schicht nieder und führt damit zu einer Beschichtung. Die Kupferschicht auf der zweiten leitfähigen Schicht kann mehrere µm dick sein.

Beispielsweise wird der Ätzschritt bei einer elektrischen Spannung von 1 V bis 3 V durchgeführt. Durch Beaufschlagung der nicht zu ätzenden leitfähigen Schichten mit einem negativen Potential kann verhindert werden, dass auch aus dieser Schicht das Kupfer entfernt wird.

Bei dem in Figur 1 gezeigten Körper 1 wird ein zweistufiger Ätzprozess durchgeführt. Dabei wird in einer ersten Ätzstufe erst eine Seitenfläche in das Ätzmedium eingebracht. Beispielsweise wird zuerst nur die vierte Seitenfläche 13 in das Ätzmedium eingebracht und eine Spannung zwischen die Hilfselektroden 6, 7 angelegt. Die erste Hilfselektrode 6 wird mit einem positiven Potential und die zweite Hilfselektrode 7 mit einem negativen Potential beaufschlagt.

In der ersten Ätzstufe werden die ersten leitfähigen Schichten 4, die mit dem positiven Potential beaufschlagt sind, zurückgeätzt. Die zweiten elektrisch leitfähigen Schichten 5, die mit dem negativen Potential verbunden sind, werden in der ersten Stufe nicht geätzt. Somit werden erste Isolationszonen in den Körper 1 eingebracht, die die ersten leitfähigen Schichten 4 von der vierten Seitenfläche 13 isolieren.

In einer zweiten Ätzstufe wird die gegenüberliegende dritte Seitenfläche 12 in das Ätzmedium eingebracht und die Polarität der Hilfselektroden 6, 7 getauscht. Somit werden die zweiten leitfähigen Schichten 5 zurückgeätzt und Isolationszonen gebildet.

In einem alternativen Verfahren erfolgt das Ätzen mit einem einstufigen Prozess. Beispielsweise wird hier ein Körper vollständig eingetaucht und die Polarität der beaufschlagten Spannung nicht vertauscht. Das einstufige Verfahren kann mit dem in Figur 8 gezeigten Körper 1 durchgeführt werden.

Nach dem Ätzschritt B werden in einem Schritt C die Hilfselektroden entfernt. Dabei werden die Enden des riegelförmigen Körpers 1 aufweisend die Hilfselektroden 6, 7 abgetrennt, zum Beispiel abgesägt.

In einem Verfahrensschritt D wird der riegelförmige Körper 1 in die einzelnen Grundkörper 15 getrennt, insbesondere zersägt. Dieser Schritt D kann auch vor oder gleichzeitig mit dem Schritt C erfolgen.

In einem nachfolgenden Schritt E werden die Außenkontaktierungen 10, 11 auf die dritten und vierten Seitenflächen 12, 13 der einzelnen Grundkörper 15 aufgebracht. Beispielsweise wird hierzu eine Metallisierungspaste aufgebracht, die anschließend eingebrannt wird.

Alternativ kann Schritt E vor Schritt D oder vor Schritt C erfolgen. Beispielsweise wird die Metallisierungspaste vor dem Trennen des Körpers 1 in die einzelnen Grundkörper 15 auf die Seitenflächen 10, 11 aufgebracht. Beispielsweise kann die Metallisierung ganzflächig auf die Seitenflächen 12, 13 aufgebracht werden.

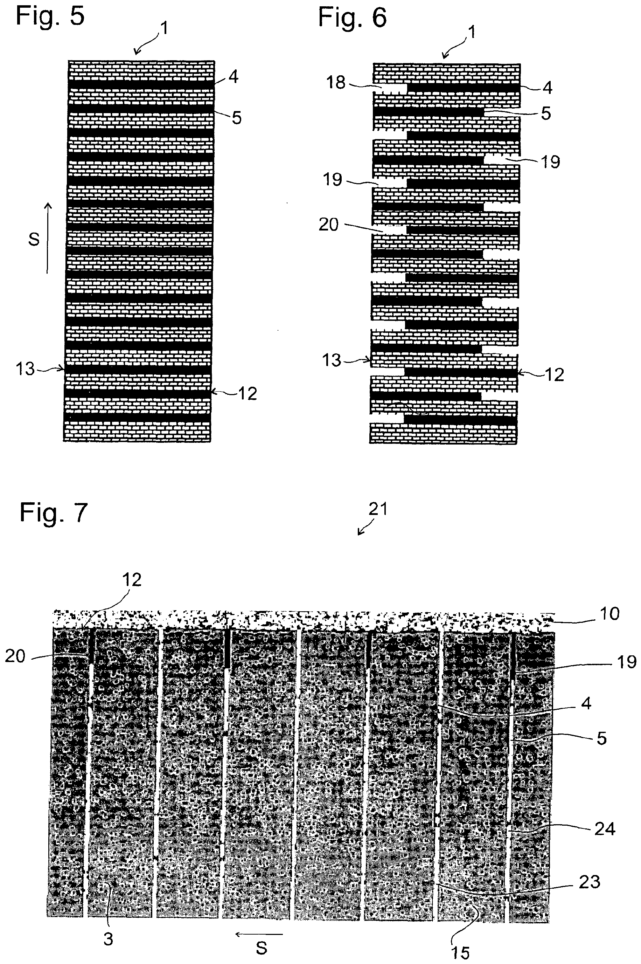

Figur 5 zeigt im Querschnitt den Körper 1 aus Figur 1 vor Durchführung des Ätzschritts B. Der Querschnitt verläuft entlang einer der in Figur 1 gezeigten Schnittlinien 2 oder parallel dazu. Hier reichen die ersten und zweiten leitfähigen Schichten 4, 5 jeweils an beide Seitenflächen 12, 13.

Figur 6 zeigt im Querschnitt den Körper 1 nach der Durchführung des Ätzschritts B. Die ersten leitfähigen Schichten 4 sind auf den vierten Seitenflächen 13 und die zweiten leitfähigen Schichten 5 auf den dritten Seitenflächen 12 zurückgeätzt. Somit sind im Körper 1 nun Vertiefungen 20 ausgebildet, die die ersten und zweiten leitfähigen Schichten 4, 5 abwechselnd von den gegenüberliegenden Seitenflächen 12, 13 isolieren. Die Vertiefungen 20 bilden somit erste und zweite Isolationszonen 18, 19. Weiterhin wirken die Vertiefungen 20 als Schwachstellen im Körper 1, die zur kontrollierten Risserzeugung und Rissführung dienen.

Figur 7 zeigt ein Schliffbild eines durch das vorhergehende Verfahren hergestellten Vielschichtbauelements 21 aufweisend einen Grundkörper 15. Die ersten elektrisch leitfähigen Schichten 4 reichen bis zur dritten Seitenfläche 12 und sind dort mit der ersten Außenkontaktierung 10 gemeinsam elektrisch kontaktiert. Die zweiten elektrisch leitfähigen Schichten 5 sind von der dritten Seitenfläche 12 zurückgeätzt und durch zweite Isolationszonen 19 von der ersten Außenkontaktierung 10 elektrisch isoliert. Durch die ersten leitfähigen Schichten 4 werden erste Elektroden 23 und durch die zweiten leitfähigen Schichten 5 zweite Elektroden 24 des Vielschichtbauelements gebildet. In diesem Fall verlaufen Vertiefungen 20, die als Sollbruchbereiche wirken, in einer Ebene mit Elektrodenschichten 23, 24.

In einer alternativen Ausführungsform kann der Körper Vertiefungen 20 aufweisen, die nicht in einer Ebene von Elektrodenschichten 23, 24 verlaufen. Ein derartiger Körper ist ähnlich wie der in Figur 7 gezeigte Körper, weist aber zusätzlich zwischen Ebenen, in denen Elektrodenschichten 23, 24 verlaufen, Ebenen auf, in denen Vertiefungen 20 und keine Elektrodenschichten 23, 24 ausgebildet sind.

Figur 8 zeigt eine schematische perspektivische Ansicht eines Körpers 81 gemäß einer weiteren Ausführungsform zur Herstellung von Vielschichtbauelementen.

Der Körper 81 ist ähnlich aufgebaut wie der in Figur 1 gezeigte Körper 1, unterscheidet sich aber in der Anordnung und Ausgestaltung der leitfähigen Schichten 84, 85, 86. Die ersten leitfähigen Schichten 84 dienen zur Erzeugung von Sollbruchbereichen, jedoch nicht als Elektrodenschichten im späteren Vielschichtbauelement. Vorzugsweise werden die ersten leitfähigen Schichten 84 im Ätzschritt vollständig entfernt, sodass das Vielschichtbauelement anstelle der ersten leitfähigen Schichten 84 Vertiefungen aufweist. Weiterhin weist der Körper 81 zweite und dritte leitfähige Schichten 85, 86 auf, die als Elektrodenschichten für das spätere Vielschichtbauelement dienen.

Die ersten leitfähigen Schichten 84 sind mit der ersten Hilfselektrode 6 elektrisch verbunden. Die zweiten und dritten leitfähigen Schichten 85, 86 sind mit der gegenüberliegenden zweiten Hilfselektrode 7 verbunden.

Die zweiten leitfähigen Schichten 85 sind von der dritten Seitenfläche 12 beabstandet und reichen bis zur vierten Seitenfläche 13. Die dritten leitfähigen Schichten 86 sind von der vierten Seitenfläche 13 beabstandet und reichen bis zur dritten Seitenfläche 12. Somit sind bereits vor dem Ätzschritt Isolationszonen vorgesehen, die eine abwechselnde Isolierung der späteren Elektrodenschichten von den Außenkontaktierungen 10, 11 ermöglichen.

Die ersten leitfähigen Schichten 84 sind nur in der Nähe der dritten und vierten Seitenfläche 12, 13 angeordnet, verlaufen aber nicht bis zu einem mittigen Bereich des Körpers 81. Ein mittiger Bereich umfasst den Bereich, der auf halber Höhe H des Körpers 81 liegt. Somit sind die ersten leitfähigen Schichten 84 als streifenförmige Schichten ausgebildet, die entlang den Seitenflächen 12, 13 verlaufen.

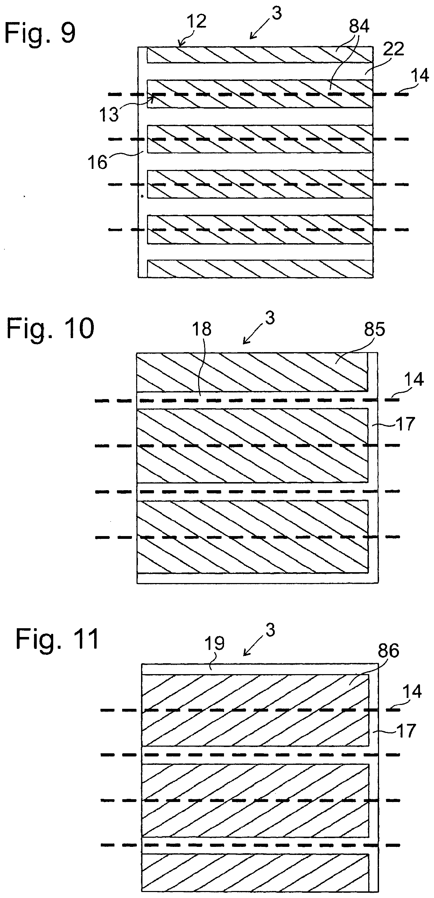

In den Figuren 9, 10 und 11 sind analog zu den Figuren 2 und 3 Aufsichten auf grüne dielektrische Schichten 3, d. h., Grünfolien, zu sehen. Auf den Grünfolien sind erste, zweite und dritte elektrisch leitfähige Schichten 84, 85, 86 aufgebracht. Die Grünfolien werden zu einem Block gestapelt, der schließlich entlang der Schnittlinien 14 in riegelförmige Körper 81 gemäß Figur 8 zerlegt wird. Vorzugsweise werden Grünfolien, auf denen zweite und dritte leitfähige Schichten 85, 86 aufgebracht sind, abwechselnd übereinander gestapelt. Dazwischen werden in regelmäßigen Abständen, z. B. alle 10 Grünfolien, Grünfolien mit den ersten leitfähigen Schichten 84 angeordnet.

Figur 9 zeigt eine dielektrische Schicht 3, auf der eine erste leitfähige Schicht 84 aufgebracht ist. Die erste leitfähige Schicht 84 ist nur in den Bereichen angeordnet, die später an die dritten und vierten Seitenflächen 12, 13 angrenzen. Ein mittiger Bereich 22 der dielektrischen Schicht 3 ist frei von der ersten leitfähigen Schicht 84. Somit weist die erste leitfähige Schicht 84 zwei streifenartige Teilschichten auf. Weiterhin ist eine erste temporäre Isolationszone 16 zur Isolierung von der zweiten Hilfselektrode 7 vorgesehen.

In Figur 10 ist eine zweite leitfähige Schicht 85 abgebildet. Die zweite leitfähige Schicht 85 ist durch eine zweite temporäre Isolationszone 17 von der ersten Seitenfläche 8 beabstandet so dass eine Isolierung von der ersten Hilfselektrode 6 hergestellt wird. Weiterhin ist eine zweite Isolationszone 18 vorgesehen, die zur Isolierung von einer der späteren Außenkontaktierungen dient.

In Figur 11 ist eine dritte elektrisch leitfähige Schicht 86 abgebildet. An der gleichen Stelle wie bei der zweiten leitfähigen Schicht 85 ist eine zweite temporäre Isolationszone 17 vorgesehen, mit der die dritte leitfähige Schicht 86 von der ersten Hilfselektrode 6 isoliert wird. Weiterhin ist eine zweite Isolationszone 19 vorgesehen, um diese Schicht 24 von einer der Außenkontaktierungen im Vielschichtbauelement zu isolieren.

Die dielektrischen Schichten 3 aus den Figuren 9, 10, 11 werden übereinander gestapelt, wobei die dielektrischen Schichten 3, auf denen erste leitfähige Schichten 84 aufgebracht sind, vorzugsweise weniger oft im Stapel vorhanden sind als die dielektrischen Schichten 3 mit den zweiten und dritten leitfähigen Schichten 85, 86.

Der Block wird wie oben zu den Figuren 2 und 3 beschrieben weiter prozessiert und es wird der riegelförmige Körper 81 aus Figur 8 gebildet.

Anschließend wird der Körper 81 ähnlich zu Figur 4 beschreiben weiterprozessiert. Es werden die ersten leitfähigen Schichten 84 mit der ersten Hilfselektrode 6 verbunden. Die zweiten und dritten leitfähigen Schichten 85, 86 werden mit der zweiten Hilfselektrode 7 verbunden.

Der Ätzschritt B wird in einem einstufigen Verfahren durchgeführt. Dazu wird der Körper 81 vollständig in das Ätzmedium eingebracht. Die erste Hilfselektrode 6 wird mit einem positiven Potential beaufschlagt und die zweite Hilfselektrode 7 wird mit einem negativen Potential beaufschlagt. Durch Beaufschlagung mit einem negativen Potential soll ein Ätzen, insbesondere ein rein chemisches Ätzen, der zweiten und dritten leitfähigen Schichten 85, 86 kompensiert oder verhindert werden. Insbesondere kann die Beaufschlagung mit einem negativen Potential zu einer Abscheidung von Material auf den zweiten und dritten leitfähigen Schichten 85, 86 führen. Um die Abscheidungsrate besser steuern zu können, kann in das Ätzmedium eine separate dritte Hilfselektrode eingebracht werden.

Somit werden Vertiefungen an der Stelle der ersten leitfähigen Schichten 84 eingebracht, wobei hier in einer Ätzstufe Vertiefungen an beiden Seitenflächen 12, 13 eingeätzt werden. Die ersten leitfähigen Schichten 84 können im Ätzverfahren vollständig entfernt werden.

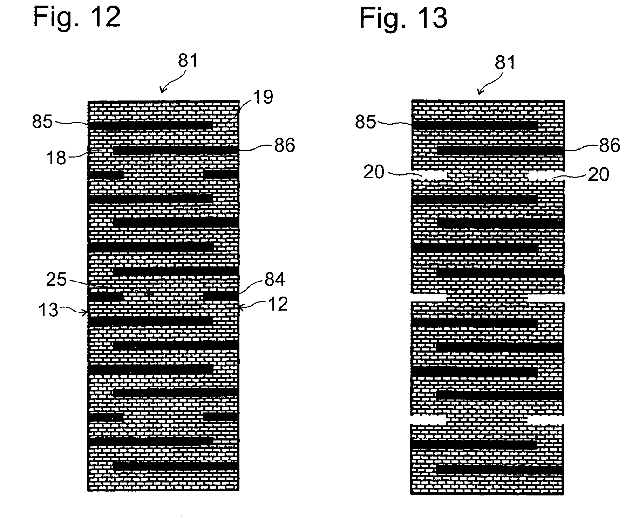

In Figur 12 ist im Schnittbild entlang oder parallel zu den Trennlinien 2 der Körper 81 aus Figur 8 vor dem Ätzschritt B abgebildet. Die ersten leitfähigen Schichten 84 sind im Bereich der dritten und vierten Seitenflächen 12, 13 vorhanden, während der mittige Bereich 25 von diesen leitfähigen Schichten 84 frei ist. Die zweiten leitfähigen Schichten 85 reichen bis zur vierten Seitenfläche 13 und sind durch zweite Isolationszonen 19 von der dritten Seitenfläche 13 beabstandet. Die dritten leitfähigen Schichten 86 reichen bis zur dritten Seitenfläche 13 und sind von der vierten Seitenfläche 12 durch erste Isolationszonen 18 beabstandet.

In Figur 13 ist der Körper 81 nach dem Ätzprozess zu sehen. Die zweiten und dritten leitfähigen Schichten 85, 86 sind unverändert geblieben. Die ersten leitfähigen Schichten 84 wurden im Ätzprozess vollständig entfernt, sodass an diesen Stellen nun Vertiefungen 20 ausgebildet sind.

Aus dem in Figur 8 gezeigten Körper 81 werden in dem beschriebenen Verfahren Vielschichtbauelemente hergestellt, bei denen Sollbruchbereiche in Ebenen angeordnet sind, in denen keine Elektrodenschichten verlaufen. Darüber hinaus werden die Isolationszonen 18, 19 schon beim Aufbringen der elektrisch leitfähigen Schichten 85, 86 auf die dielektrischen Schichten 3 gebildet. Die Isolationszonen 18, 19 haben hier keine Funktion als Sollbruchbereiche.

### Bezugszeichenliste

- 1: Körper
- 2: Trennlinien für Trennung des Riegels
- 3: dielektrische Schicht
- 4: erste leitfähige Schicht
- 5: zweite leitfähige Schicht
- 6: erste Hilfselektrode
- 7: zweite Hilfselektrode
- 8: erste Seitenfläche
- 9: zweite Seitenfläche
- 10: erste Außenkontaktierung
- 11: zweite Außenkontaktierung
- 12: dritte Seitenfläche
- 13: vierte Seitenfläche
- 14: Trennlinien für Trennung des Blocks
- 15: spätere Grundkörper
- 16: erste temporäre Isolationszone
- 17: zweite temporäre Isolationszone
- 18: erste Isolationszone
- 19: zweite Isolationszone
- 20: Vertiefung
- 21: Vielschichtbauelement
- 22: mittiger Bereich
- 23: erste Elektrode
- 24: zweite Elektrode
- 81: Körper
- 84: erste leitfähige Schicht
- 85: zweite leitfähige Schicht
- 86: dritte leitfähige Schicht

- H: Höhe des Riegels
- S: Stapelrichtung

## Patentansprüche

1. Verfahren zur Herstellung eines Vielschichtbauelements mit den Schritten:
A) Bereitstellen eines Körpers (1, 81) aufweisend übereinander angeordnete dielektrische Schichten (3) und dazwischen angeordnete erste und zweite elektrisch leitfähige Schichten (4, 84, 5, 85), wobei die ersten leitfähigen Schichten (4, 84) mit einer ersten Hilfselektrode (6) und die zweiten leitfähigen Schichten (5, 85) mit einer zweiten Hilfselektrode (7) verbunden sind, wobei die Hilfselektroden (6, 7) an zwei gegenüberliegenden Seitenflächen (8, 9) des Körpers (1, 81) angeordnet sind,
B) Einbringen zumindest eines Teils des Körpers (1, 81) in ein Ätzmedium und Anlegen einer Spannung zwischen der ersten und zweiten Hilfselektrode (6, 7), wodurch ein Materialabtrag aus wenigstens einer der ersten und zweiten elektrisch leitfähigen Schichten (4, 84, 5, 85) erzeugt wird.

2. Verfahren nach Anspruch 1,
wobei mit dem Anlegen einer Spannung ein Materialtransport zwischen den ersten und zweiten elektrisch leitfähigen Schichten (4, 84, 5, 85) gesteuert wird.

3. Verfahren nach einem der Ansprüche 1 oder 2,
wobei mit dem Anlegen einer Spannung wenigstens eine der elektrisch leitfähigen Schichten (4, 84, 5, 85) elektrisch gesteuert geätzt oder elektrisch gesteuert beschichtet wird.

4. Verfahren nach einem der Ansprüche 1 bis 3,
bei dem in Schritt B) eine dritte Hilfselektrode in das Medium eingebracht wird.

5. Verfahren nach einem der Ansprüche 1 bis 4,
wobei der Körper (1, 81) vor dem Einbringen in das Medium gesintert wird.

6. Verfahren nach einem der Ansprüche 1 bis 5,
wobei wenigstens die erste leitfähige Schicht (4, 84) Kupfer enthält.

7. Verfahren nach einem der Ansprüche 1 bis 6,
wobei das Medium Eisen(III)-Chlorid, Natriumpersulfat oder Kupferchlorid aufweist.

8. Verfahren nach einem der Ansprüche 1 bis 7,
wobei der Materialabtragungsprozess einstufig ist.

9. Verfahren nach einem der Ansprüche 1 bis 8,
wobei der Materialabtragungsprozess mehrstufig ist.

10. Verfahren nach einem der Ansprüche 1 bis 9,
wobei in wenigstens einer Stufe des Materialabtragungsprozesses die erste Hilfselektrode (6) mit einem positiven Potential und die zweite Hilfselektrode (7) mit einem negativen Potential beaufschlagt wird.

11. Verfahren nach einem der Ansprüche 1 bis 10,
wobei die ersten und zweiten leitfähigen Schichten (4, 5) im Vielschichtbauelement (21) als Elektroden (23, 24) dienen.

12. Verfahren nach einem der Ansprüche 1 bis 10,
wobei die ersten leitfähigen Schichten (84) im Vielschichtbauelement (21) keine Funktion als Elektroden (23, 24) haben.

13. Verfahren nach einem der Ansprüche 1 bis 12,
wobei der Körper (1, 81) dritte leitfähige Schichten (86) aufweist, die mit der zweiten Hilfselektrode (7) verbunden sind und wobei die dritten leitfähigen Schichten (86) eine andere Geometrie aufweisen als die zweiten leitfähigen Schichten (85).

14. Verfahren nach Anspruch 13,
wobei die zweiten und dritten leitfähigen Schichten (85, 86) im Vielschichtbauelement (21) als Elektroden (23, 24) dienen.

15. Verfahren nach einem der Ansprüche 1 bis 14,
wobei die ersten leitfähigen Schichten (84) im Ätzprozess vollständig entfernt werden.

16. Verfahren nach einem der Ansprüche 1 bis 15,
aufweisend den weiteren Schritt:
C) Entfernen der Hilfselektroden (6, 7).

17. Verfahren nach einem der Ansprüche 1 bis 16,
aufweisend den weiteren Schritt:
D) Trennen des Körpers (1, 81) in mehrere Grundkörper (15) für Vielschichtbauelemente (21).

18. Vielschichtbauelement,
aufweisend einen Grundkörper (15) mit entlang einer Stapelrichtung (S) übereinander angeordneten dielektrischen Schichten (3) und dazwischen angeordneten Elektrodenschichten (23, 24), wobei der Grundkörper wenigstens eine Vertiefung (20) aufweist und wobei die Vertiefung (20) in einer Ebene verläuft, in der keine Elektrodenschicht (23, 24) angeordnet ist und die senkrecht zu der Stapelrichtung (S) angeordnet ist, und wobei die Vertiefung (20) an eine Seitenfläche (12, 13) reicht.

## Claims

1. Method for producing a multilayer component comprising the following steps:
A) providing a body (1, 81) having dielectric layers (3) arranged one above another and first and second electrically conductive layers (4, 84, 5, 85) arranged therebetween, wherein the first conductive layers (4, 84) are connected to a first auxiliary electrode (6) and the second conductive layers (5, 85) are connected to a second auxiliary electrode (7), wherein the auxiliary electrodes (6, 7) are arranged at two opposite side surfaces (8, 9) of the body (1, 81),
B) introducing at least one part of the body (1, 81) into an etching medium and applying a voltage between the first and second auxiliary electrodes (6, 7), as a result of which a material removal from at least one of the first and second electrically conductive layers (4, 84, 5, 85) is produced.

2. Method according to Claim 1,
wherein a material transport between the first and second electrically conductive layers (4, 84, 5, 85) is controlled by applying a voltage.

3. Method according to either of Claims 1 and 2,
wherein at least one of the electrically conductive layers (4, 84, 5, 85) is etched in an electrically controlled manner or coated in an electrically controlled manner by applying a voltage.

4. Method according to any of Claims 1 to 3,
wherein in step B) a third auxiliary electrode is introduced into the medium.

5. Method according to any of Claims 1 to 4,
wherein the body (1, 81) is sintered before being introduced into the medium.

6. Method according to any of Claims 1 to 5,
wherein at least the first conductive layer (4, 84) contains copper.

7. Method according to any of Claims 1 to 6,
wherein the medium comprises iron(III) chloride, sodium persulfate or copper chloride.

8. Method according to any of Claims 1 to 7,
wherein the material removal process is a single-stage process.

9. Method according to any of Claims 1 to 8,
wherein the material removal process is a multi-stage process.

10. Method according to any of Claims 1 to 9,
wherein, in at least one stage of the material removal process, a positive potential is applied to the first auxiliary electrode (6) and a negative potential is applied to the second auxiliary electrode (7).

11. Method according to any of Claims 1 to 10,
wherein the first and second conductive layers (4, 5) in the multilayer component (21) serve as electrodes (23, 24).

12. Method according to any of Claims 1 to 10,
wherein the first conductive layers (84) in the multilayer component (21) have no function as electrodes (23, 24).

13. Method according to any of Claims 1 to 12,
wherein the body (1, 81) has third conductive layers (86), which are connected to the second auxiliary electrode (7), and wherein the third conductive layers (86) have a different geometry than the second conductive layers (85).

14. Method according to Claim 13,
wherein the second and third conductive layers (85, 86) in the multilayer component (21) serve as electrodes (23, 24).

15. Method according to any of Claims 1 to 14,
wherein the first conductive layers (84) are completely removed in the etching process.

16. Method according to any of Claims 1 to 15, comprising the following further step:
C) removing the auxiliary electrodes (6, 7).

17. Method according to any of Claims 1 to 16, comprising the following further step:
D) separating the body (1, 81) into a plurality of main bodies (15) for multilayer components (21).

18. Multilayer component,
comprising a main body (15) having dielectric layers (3) arranged one above another along a stacking direction (S) and electrode layers (23, 24) arranged therebetween, wherein the main body has at least one depression (20), and wherein the depression (20) runs in a plane in which no electrode layer (23, 24) is arranged and which is arranged perpendicularly to the stacking direction (S), and wherein the depression (20) extends to a side surface (12, 13).

## Revendications

1. Procédé de fabrication d'un élément multicouche comprenant les étapes suivantes :
A) fournir un corps (1, 81) comportant des couches diélectriques superposées (3) et des premières et des deuxièmes couches électriquement conductrices (4, 84, 5, 85) disposées entre celles-ci, dans lequel les premières couches conductrices (4, 84) sont reliées à une première électrode auxiliaire (6) et les deuxièmes couches conductrices (5, 85) sont reliées à une deuxième électrode auxiliaire (7), dans lequel les électrodes auxiliaires (6, 7) sont disposées sur deux faces latérales opposées (8, 9) du corps (1, 81),
B) introduire au moins une partie du corps (1, 81) dans un milieu de gravure et appliquer une tension entre les première et deuxième électrodes auxiliaires (6, 7), de sorte qu'un enlèvement de matériau est généré à partir d'au moins l'une des premières et deuxièmes couches électriquement conductrices (4, 84, 5, 85).

2. Procédé selon la revendication 1,
dans lequel un transport de matériau entre les premières et deuxièmes couches électriquement conductrices (4, 84, 5, 85) est commandé par l'application d'une tension.

3. Procédé selon l'une des revendications 1 ou 2,
dans lequel au moins l'une des couches électriquement conductrices (4, 84, 5, 85) est gravée ou revêtue d'une manière électriquement commandée en association avec l'application d'une tension.

4. Procédé selon l'une des revendications 1 à 3,
dans lequel une troisième électrode auxiliaire est introduite dans le milieu lors de l'étape B).

5. Procédé selon l'une des revendications 1 à 4,
dans lequel le corps (1, 81) est fritté avant l'introduction dans le milieu.

6. Procédé selon l'une des revendications 1 à 5,
dans lequel au moins la première couche conductrice (4, 84) contient du cuivre.

7. Procédé selon l'une des revendications 1 à 6,
dans lequel le milieu comporte du chlorure de fer(III), du persulfate de sodium ou du chlorure de cuivre.

8. Procédé selon l'une des revendications 1 à 7,
dans lequel le procédé d'enlèvement de matériau est à un seul stade.

9. Procédé selon l'une des revendications 1 à 8,
dans lequel le processus d'enlèvement de matériau est en plusieurs stades.

10. Procédé selon l'une des revendications 1 à 9,
dans lequel la première électrode auxiliaire (6) est soumise à un potentiel positif et la deuxième électrode auxiliaire (7) est soumise à un potentiel négatif au cours d'au moins un stade du processus d'enlèvement de matériau.

11. Procédé selon l'une des revendications 1 à 10,
dans lequel les premières et deuxièmes couches conductrices (4, 5) du composant multicouche (21) servent d'électrodes (23, 24).

12. Procédé selon l'une des revendications 1 à 10,
dans lequel les premières couches conductrices (84) de l'élément multicouche (21) ne présentent pas de fonction d'électrodes (23, 24).

13. Procédé selon l'une des revendications 1 à 12,
dans lequel le corps (1, 81) comprend des troisièmes couches conductrices (86) qui sont reliées à la deuxième électrode auxiliaire (7) et dans lequel les troisièmes couches conductrices (86) présentent une géométrie différente de celle des deuxièmes couches conductrices (85) .

14. Procédé selon la revendication 13,
dans lequel les deuxièmes et troisièmes couches conductrices (85, 86) servent d'électrodes (23, 24) dans l'élément multicouche (21).

15. Procédé selon l'une des revendications 1 à 14,
dans lequel les premières couches conductrices (84) sont entièrement enlevées au cours du processus de gravure.

16. Procédé selon l'une des revendications 1 à 15, comprenant l'étape supplémentaire suivante :
C) enlever les électrodes auxiliaires (6, 7).

17. Procédé selon l'une des revendications 1 à 16, comprenant l'étape supplémentaire suivante :
D) séparer le corps (1, 81) en plusieurs corps de base (15) destinés à des éléments multicouches (21).

18. Élément multicouche,
comprenant un corps de base (15) muni de couches diélectriques (3) superposées le long d'une direction d'empilement (S) et des couches d'électrodes (23, 24) disposées entre celles-ci, dans lequel le corps de base présente au moins un évidement (20) et
dans lequel l'évidement (20) s'étend dans un plan dans lequel aucune couche d'électrode (23, 24) n'est présente et qui est disposé perpendiculairement à la direction d'empilement (S), et
dans lequel l'évidement (20) se prolonge sur une surface latérale (12, 13).
